# FASCICULE DE BREVET EUROPEEN

(11) **EP 2 501 213 B1**
(45) Date de publication et mention de la délivrance du brevet: **13.11.2013**
(21) Numéro de dépôt: 12159528.4
(22) Date de dépôt: 14.03.2012
(51) Int. Cl.: H05K 7/20

(54) **Dispositif de conversion d'énergie, notamment pour un système d'entrainement électrique de station sous-marine de compression et de pompage**
Vorrichtung zur Energieumwandlung, insbesondere für ein elektrisches Antriebssystem einer Unterwasser-Kompressions- und Pumpstation
Energy conversion device, in particular for an electric drive system of an underwater compression and pumping station

(30) Priorité: 14.03.2011 FR 1152037
(43) Date de publication de la demande: 19.09.2012
(73) Titulaire: GE Energy Power Conversion Technology Limited, Rugby Warwickshire CV21 1BU (GB)
(72) Inventeur: Baerd, Henri, 77430 Champagne Sur Seine (FR); Vedachalam, Narayanaswamy, 60091 Chennai (IN)
(74) Mandataire: Serjeants LLP

(56) Documents cités:
- EP-A1- 1 310 759

## Description

La présente invention concerne un dispositif de conversion d'énergie, également appelé convertisseur, notamment pour un système d'entraînement électrique de station sous-marine de compression et de pompage.

Une telle station sous-marine est destinée à l'exploitation de pétrole ou de gaz naturel, généralement en eaux profondes.

EP 1 310 759 décrit un exemple de dispositif de conversion d'énergie, comportant notamment un module de puissance et des moyens de refroidissement de ce module de puissance.

On connaît également déjà, dans l'état de la technique, un dispositif de conversion d'énergie destiné à équiper un système d'entraînement électrique pour une telle station sous-marine de compression et de pompage. Un tel dispositif de conversion d'énergie comporte au moins un module de puissance destiné à assurer la fonction de conversion d'énergie, de manière connue en soi.

Le dispositif de conversion d'énergie comporte également des moyens de refroidissement du module de puissance, et une enceinte étanche de logement du module de puissance et des moyens de refroidissement.

Généralement, les moyens de refroidissement comprennent un circuit de refroidissement dans lequel circule un fluide caloporteur, passant par un échangeur de chaleur avec le module de puissance. Les moyens de refroidissement comprennent également au moins une pompe d'entraînement du fluide caloporteur en circulation dans le circuit.

Lorsque le dispositif de conversion d'énergie est installé en eaux profondes, il est difficile, voire impossible, d'y accéder pour y mener des opérations de maintenance. Ainsi, ce dispositif de conversion d'énergie doit pouvoir fonctionner sans nécessiter de maintenance pendant une longue durée, généralement au moins cinq ans.

Toutefois, la différence de pression entre le fluide caloporteur circulant dans le circuit de refroidissement et l'intérieur de l'enceinte, qui peut par exemple atteindre 10 bars, favorise l'apparition de fuites du fluide caloporteur depuis le circuit de refroidissement vers l'intérieur de l'enceinte, notamment au niveau des joints statiques et dynamiques, et des raccords utilisés pour le circuit. De telles fuites peuvent également apparaître à la suite de dégradations du circuit de refroidissement, par exemple dues au temps.

De telles fuites du fluide caloporteur réduisent la durée de vie du dispositif de conversion d'énergie, si bien qu'il peut être difficile d'assurer une durée de vie d'au moins cinq ans pour ce dispositif de conversion d'énergie.

L'invention a notamment pour but de remédier à cet inconvénient, en fournissant un dispositif de conversion d'énergie dont la durée de vie est satisfaisante même en cas de fuites éventuelles du fluide caloporteur.

A cet effet, l'invention a notamment pour objet un dispositif de conversion d'énergie, notamment pour un système d'entraînement électrique de station sous-marine de compression et de pompage, comportant un module de puissance, des moyens de refroidissement du module de puissance, et une enceinte étanche de logement du module de puissance et d'au moins une partie des moyens de refroidissement, les moyens de refroidissement comprenant :
- un circuit de refroidissement, dans lequel circule un fluide caloporteur,
- un premier échangeur de chaleur avec le module de puissance, à travers lequel passe le fluide caloporteur du circuit de refroidissement, et
- au moins une pompe d'entraînement du fluide caloporteur en circulation dans le circuit,
**caractérisé en ce que** :
- l'enceinte comporte une zone de réception de fluide caloporteur, emplie de fluide caloporteur,
- le circuit de refroidissement comprend un orifice d'entrée dans le circuit, ménagé en amont de la pompe d'entraînement, et débouchant dans le fluide caloporteur de la zone de réception.

En cas de fuite de fluide caloporteur depuis le circuit, cette perte de fluide caloporteur génère une dépression dans ce circuit, entraînant alors une aspiration par l'orifice d'entrée. Puisque cet orifice d'entrée débouche dans le fluide caloporteur de la zone de réception, ce fluide est aspiré pour être réinjecté dans le circuit. En d'autres termes, du fluide caloporteur est réinjecté dans le circuit de façon à compenser les fuites.

Ainsi, le circuit de refroidissement peut continuer à fonctionner de manière efficace, même en cas de fuites.

De préférence, le circuit de refroidissement est agencé au-dessus ou dans la zone de réception, si bien que les fuites éventuelles de fluide caloporteur provenant de ce circuit tombent par gravité dans la zone de réception.

Un dispositif de conversion d'énergie selon l'invention peut comporter en outre une ou plusieurs des caractéristiques suivantes, prises seules ou selon toutes les combinaisons techniquement possibles :
- l'orifice d'entrée est muni d'un clapet anti-retour, n'autorisant le passage de fluide caloporteur que depuis la zone de réception vers le circuit de refroidissement ;
- le dispositif de conversion d'énergie comprend un filtre agencé entre l'orifice d'entrée et le circuit ;
- le fluide caloporteur est un fluide diélectrique, par exemple une huile diélectrique ;
- la pompe d'entraînement est agencée dans la zone de réception de façon à être immergée dans le fluide caloporteur de cette zone de réception ;
- la zone de réception s'étend dans l'enceinte de sorte que le circuit de refroidissement soit immergé dans le fluide caloporteur de cette zone de réception ;
- le circuit de refroidissement est agencé au dessus de la zone de réception, et il est muni d'une conduite d'aspiration, s'étendant depuis un embranchement agencé en amont de la pompe d'entraînement, jusqu'à l'orifice d'entrée qui est immergé dans le fluide caloporteur de la zone de réception ;
- l'enceinte, à l'exception de la zone de réception qui est emplie de fluide caloporteur, est emplie de gaz, de préférence de gaz neutre, par exemple l'azote ; et
- la zone de réception s'étend dans toute l'enceinte, le dispositif de conversion d'énergie comportant un dispositif de limitation de pression, destiné à limiter la pression dans l'enceinte en recevant en partie le fluide caloporteur emplissant cette enceinte lorsque ce fluide caloporteur se dilate.

L'invention concerne également un système d'entraînement électrique de station sous-marine de compression et de pompage, comportant au moins un dispositif de conversion d'énergie tel que défini précédemment.

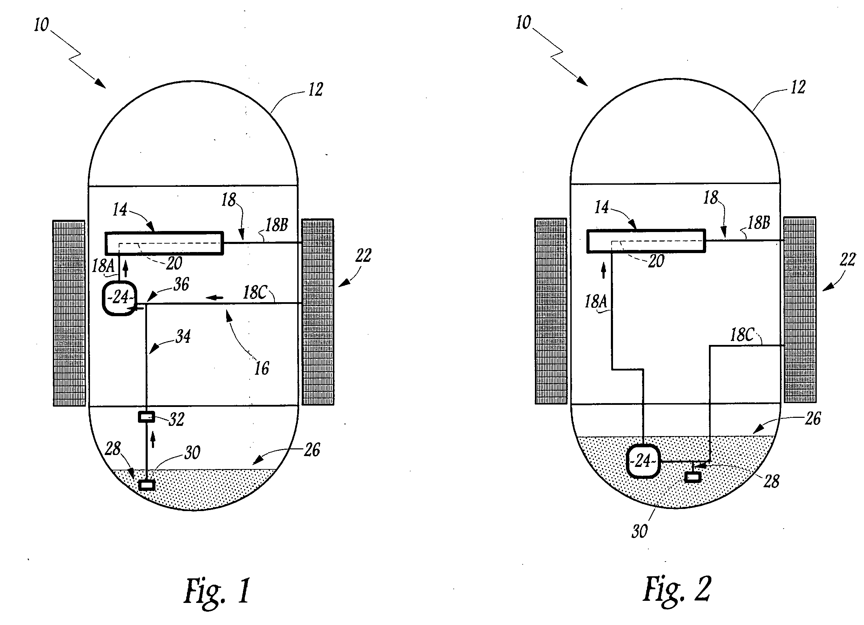

L'invention sera mieux comprise à la lecture de la description qui va suivre, donnée uniquement à titre d'exemple et faite en se référant aux figures annexées, parmi lesquelles les figures 1 à 4 représentent chacun schématiquement un dispositif de conversion d'énergie, respectivement selon un premier à quatrième exemple de mode de réalisation de l'invention.

On a représenté, sur la Figure 1, un dispositif 10 de conversion d'énergie selon un premier exemple de mode de réalisation de l'invention.

Le dispositif de conversion d'énergie 10 est notamment destiné à équiper un système d'entraînement électrique de station sous-marine de compression et de pompage. Ainsi, ce dispositif de conversion d'énergie 10 est destiné à être agencé sur un fond marin, à une profondeur généralement comprise entre quelques mètres et plusieurs kilomètres.

Le dispositif de conversion d'énergie 10 comporte une enceinte étanche 12, dans laquelle sont logés un module de puissance 14 et un dispositif 16 de refroidissement du module de puissance 14.

De manière connue en soi, le module de puissance 14 comporte des éléments d'électronique de puissance, et il est propre à assurer la fonction de conversion d'énergie.

Les moyens de refroidissement 16 comportent un circuit 18 de refroidissement, dans lequel circule un fluide caloporteur.

Avantageusement, le fluide caloporteur est de l'huile diélectrique, telle que de l'huile silicone ou de l'huile commercialisée sous la référence MIDEL 7131 par Midel®. Le choix d'une telle huile comme fluide caloporteur a notamment pour avantage de ne pas altérer la tenue diélectrique du matériel qui serait aspergé par ce fluide, et également de ne pas augmenter l'humidité dans l'enceinte 12 en cas de fuite.

Les moyens de refroidissement 16 comportent également un premier échangeur de chaleur 20 de type classique, destiné à échanger de la chaleur avec le module de puissance 14, à travers lequel passe le circuit de refroidissement 18. Le premier échangeur de chaleur 20 présente par exemple la forme d'une plaque creuse, contre laquelle sont agencés les éléments d'électronique de puissance du module 14, et dans laquelle circule le fluide caloporteur. L'échangeur de chaleur peut également comporter des moyens d'échanges thermiques par circulation forcée à travers des composants du module de puissance 14, telles que des résistances et des éléments bobinés.

Les moyens de refroidissement 16 comportent également un second échangeur de chaleur extérieur 22 de type classique, agencé à l'extérieur de l'enceinte 12, de sorte que le fluide caloporteur circulant dans ce second échangeur de chaleur 22 échange de la chaleur avec l'environnement du dispositif de conversion d'énergie 10, c'est-à-dire de l'eau de mer. On notera que l'eau de mer, notamment à grande profondeur, présente habituellement une température inférieure à dix degrés Celsius, généralement environ égale à quatre degrés Celsius.

En variante, le second échangeur de chaleur 22 peut être agencé à l'intérieur de l'enceinte 12, en contact direct avec la paroi de cette enceinte 12, de façon à évacuer les calories vers l'eau de mer extérieure environnant cette enceinte 12.

Ainsi, le fluide caloporteur collecte des calories depuis le module de puissance 14 par l'intermédiaire du premier échangeur de chaleur 20, et délivre ces calories à l'eau de mer par l'intermédiaire du second échangeur de chaleur 22.

Les moyens de refroidissement 16 comportent enfin au moins une pompe 24 d'entraînement du fluide caloporteur en circulation dans le circuit 18. De préférence, les moyens de refroidissement 16 comportent au moins une pompe de secours agencée en parallèle de la pompe 24, afin de former une redondance de pompes susceptible de prendre le relais en cas de dysfonctionnement de la pompe 24.

Avantageusement, la pompe 24 est de type volumétrique.

Le circuit 18 comporte au moins une première branche 18A s'étendant entre la pompe 24 et le premier échangeur 20, en sortie de la pompe 24, au moins une deuxième branche 18B s'étendant entre le premier 20 et le second 22 échangeur, et au moins une troisième branche 18C s'étendant entre le second échangeur 22 et la pompe 24, en entrée de cette pompe 24.

L'enceinte 12 comporte une zone 26 de réception de fluide caloporteur, emplie de fluide caloporteur identique ou de type similaire à celui circulant dans le circuit de refroidissement 18.

Conformément à ce premier mode de réalisation, le circuit de refroidissement 18 est agencé au-dessus de la zone de réception 26. Ainsi, en cas de fuites du circuit de refroidissement 18, le fluide caloporteur fuyant s'écoule par gravité dans la zone de réception 26.

Le circuit de refroidissement 18 comprend par ailleurs un orifice 28 d'entrée dans le circuit 18, ménagé en amont de la pompe d'entraînement 24, débouchant dans le fluide caloporteur de la zone de réception 26.

En cas de fuites du circuit de refroidissement 18, la perte de fluide caloporteur dans le circuit 18 y génère une dépression, entraînant une aspiration par l'orifice d'entrée 28. Puisque cet orifice d'entrée 28 débouche dans le fluide caloporteur de la zone de réception 26, ce fluide caloporteur est alors aspiré pour être réinjecté dans le circuit de refroidissement 18. Les fuites de fluide caloporteur depuis le circuit 18 sont donc automatiquement compensées, ce qui permet au circuit de refroidissement 18 de continuer à fonctionner même en cas de fuites.

Avantageusement, l'orifice d'entrée 28 est muni d'un clapet anti-retour 30, n'autorisant le passage de fluide caloporteur que depuis la zone de réception 26 vers le circuit de refroidissement 18. Un tel clapet anti-retour 30 évite la perte de fluide caloporteur depuis le circuit à travers l'orifice 28.

De préférence, un filtre 32 est agencé entre l'orifice d'entrée 28 et le circuit 18, afin d'empêcher l'entrée, dans le circuit 18, d'impuretés résidant dans l'enceinte 12.

Conformément à ce premier mode de réalisation, la zone de réception 26 s'étend au fond de l'enceinte 12. Dans ce cas, le circuit de refroidissement 18 comporte une conduite d'aspiration 34 s'étendant depuis un embranchement 36 avec la troisième branche 18C du circuit 18, jusqu'à l'orifice d'entrée 28 qui est immergé dans le fluide caloporteur de la zone de réception 26. Le filtre 32 est agencé sur cette conduite d'aspiration 34, comme cela est représenté sur la Figure 1.

On notera que l'enceinte 12, à l'exception de la zone de réception 26 qui est emplie de fluide caloporteur, est emplie de gaz, de préférence de gaz neutre tel que, par exemple l'azote. Un tel gaz neutre a pour avantage de limiter la corrosion des éléments qui y résident, et d'éviter la propagation d'éventuels incendies.

On a représenté sur la Figure 2 un dispositif de conversion d'énergie 10 selon un deuxième exemple de mode de réalisation de l'invention. Sur cette figure, les éléments analogues à ceux de la figure précédente sont désignés par des références identiques.

Conformément à ce deuxième mode de réalisation, la pompe d'entraînement 24 est agencée dans la zone de réception 26, de façon à être immergée dans le fluide caloporteur emplissant cette zone de réception 26. Ainsi, à la différence du premier mode de réalisation, ce dispositif de conversion d'énergie 10 ne comporte pas de conduite d'aspiration 34, l'orifice d'entrée 28 étant directement agencé sur la troisième branche 18C du circuit 18.

Ainsi, on évite d'éventuels problèmes de fuite sur une telle conduite d'aspiration 34.

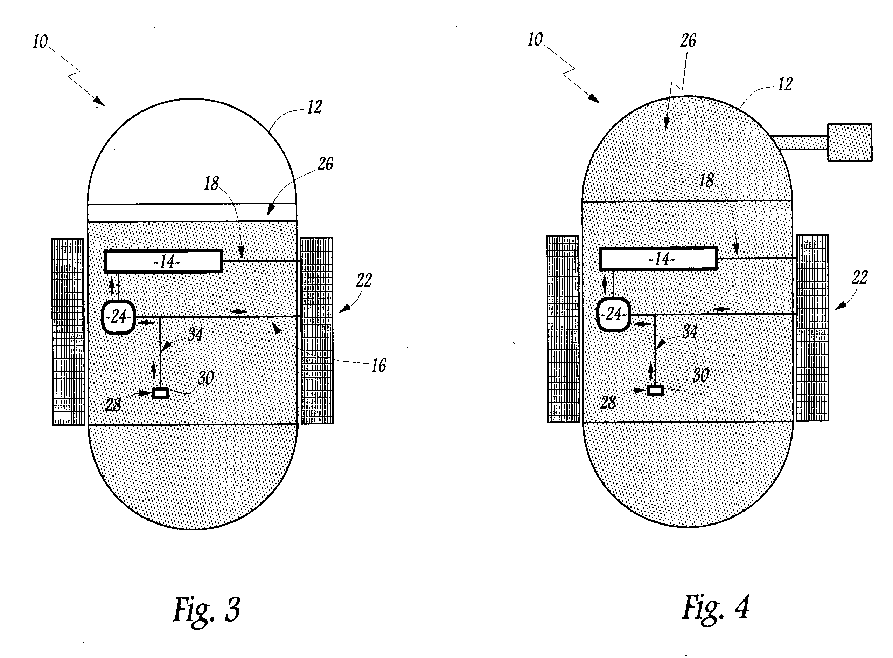

On a représenté sur la Figure 3 un troisième exemple de mode de réalisation de l'invention. Sur cette figure, les éléments analogues à ceux des figures précédentes sont désignés par des références identiques.

Conformément à ce troisième mode de réalisation, la zone de réception 26 s'étend dans l'enceinte 12 de sorte que le circuit de refroidissement 18 soit entièrement immergé dans le fluide caloporteur de cette zone de réception 26.

On notera que, dans ce mode de réalisation, l'enceinte 12 présente une zone 35 emplie de gaz neutre. Ainsi, en cas de dilatations, notamment de dilatations thermiques, du fluide caloporteur de la zone de réception 26, les volumes respectifs des zones de réception 26 et de gaz neutre 35 varient en fonction des dilatations du fluide caloporteur. Le volume de fluide caloporteur peut donc augmenter dans l'enceinte 12, sans générer de pression interne excessive. La pression interne de l'enceinte 12 reste ainsi comprise entre des seuils de pression nominaux pour la bonne tenue des éléments logés dans cette enceinte 12. A titre d'exemple, afin de permettre l'utilisation de matériel standard pour la réalisation du dispositif 10, la pression interne de l'enceinte 12 est de l'ordre de 1 bar.

Sur l'exemple de la Figure 3, le circuit de refroidissement 18 comporte une conduite 34 d'aspiration. Toutefois, en variante équivalente, l'orifice d'entrée 28 pourrait être ménagé directement sur la troisième branche 18C.

On a représenté sur la Figure 4 un dispositif de conversion d'énergie 10 selon un quatrième exemple de mode de réalisation de l'invention. Sur cette figure, les éléments analogues à ceux des figures précédentes sont désignés par des références identiques.

Conformément à ce quatrième mode de réalisation, la zone de réception 26 s'étend dans toute l'enceinte 12. En d'autres termes, l'enceinte 12 est emplie de fluide caloporteur.

Dans ce cas, le dispositif de conversion d'énergie 10 comporte un dispositif 38 de limitation de pression, destiné à limiter la pression interne de l'enceinte 12, par exemple en recevant en partie du fluide caloporteur de cette enceinte 12 en cas de dilatation de ce fluide caloporteur.

Le circuit de refroidissement 18 étant entièrement immergé dans le fluide caloporteur de la zone de réception 26, ce circuit de refroidissement 18 est similaire à celui du troisième mode de réalisation décrit précédemment.

On notera que ce mode de réalisation permet de prévoir une pression intérieure de l'enceinte 12 sensiblement égale à la pression extérieure environnant cette enceinte 12. Dans ce cas, les parois limitant l'enceinte 12 peuvent être choisies plus minces que dans les modes de réalisation précédents.

On notera que l'invention n'est pas limitée aux modes de réalisation précédemment décrits, mais pourrait présenter diverses variantes sans sortir du cadre des revendications.

Le dispositif de conversion d'énergie 10 pourrait en particulier comporter un circuit de refroidissement plus complexe que celui décrit précédemment, ou comporter plusieurs modules de puissance.

## Revendications

1. Dispositif de conversion d'énergie (10), notamment pour un système d'entraînement électrique de station sous-marine de compression et de pompage, comportant un module de puissance (14), des moyens (16) de refroidissement du module de puissance (14), et une enceinte étanche (12) de logement du module de puissance (14) et d'au moins une partie des moyens de refroidissement (16), les moyens de refroidissement (16) comprenant :
- un circuit de refroidissement (18), dans lequel circule un fluide caloporteur,
- un premier échangeur de chaleur (20) avec le module de puissance (14), à travers lequel passe le fluide caloporteur du circuit de refroidissement (18), et
- au moins une pompe (24) d'entraînement du fluide caloporteur en circulation dans le circuit (18),
**caractérisé en ce que** :
- l'enceinte (12) comporte une zone (26) de réception de fluide caloporteur, emplie de fluide caloporteur,
- le circuit de refroidissement (18) comprend un orifice (28) d'entrée dans le circuit (18), ménagé en amont de la pompe d'entraînement (24), et débouchant dans le fluide caloporteur de la zone de réception (26).

2. Dispositif de conversion d'énergie (10) selon la revendication 1, dans lequel l'orifice d'entrée (28) est muni d'un clapet anti-retour (30), n'autorisant le passage de fluide caloporteur que depuis la zone de réception (26) vers le circuit de refroidissement (18).

3. Dispositif de conversion d'énergie (10) selon la revendication 1 ou 2, comprenant un filtre (32) agencé entre l'orifice d'entrée (28) et le circuit (18).

4. Dispositif de conversion d'énergie (10) selon l'une quelconque des revendications précédentes, dans lequel le fluide caloporteur est un fluide diélectrique, par exemple une huile diélectrique.

5. Dispositif de conversion d'énergie (10) selon l'une quelconque des revendications 1 à 4, dans lequel la pompe d'entraînement (24) est agencée dans la zone de réception (26) de façon à être immergée dans le fluide caloporteur de cette zone de réception (26).

6. Dispositif de conversion d'énergie (10) selon la revendication 5, dans lequel la zone de réception (26) s'étend dans l'enceinte (12) de sorte que le circuit de refroidissement (18) soit immergé dans le fluide caloporteur de cette zone de réception (26).

7. Dispositif de conversion d'énergie (10) selon l'une quelconque des revendications 1 à 4, dans lequel le circuit de refroidissement (18) est agencé au dessus de la zone de réception (26), et il est muni d'une conduite d'aspiration (34), s'étendant depuis un embranchement (36) agencé en amont de la pompe d'entraînement (24), jusqu'à l'orifice d'entrée (28) qui est immergé dans le fluide caloporteur de la zone de réception (26).

8. Dispositif de conversion d'énergie (10) selon l'une quelconque des revendications 1 à 7, dans lequel l'enceinte (12), à l'exception de la zone de réception (26) qui est emplie de fluide caloporteur, est emplie de gaz, de préférence de gaz neutre, par exemple l'azote.

9. Dispositif de conversion d'énergie (10) selon l'une quelconque des revendications 1 à 7, dans lequel la zone de réception (26) s'étend dans toute l'enceinte (12), le dispositif de conversion d'énergie comportant un dispositif (38) de limitation de pression, destiné à limiter la pression dans l'enceinte (12) en recevant en partie le fluide caloporteur emplissant cette enceinte (12) lorsque ce fluide caloporteur se dilate.

10. Système d'entraînement électrique de station sous-marine de compression et de pompage, comportant au moins un dispositif (10) de conversion d'énergie selon l'une quelconque des revendications précédentes.

## Patentansprüche

1. Vorrichtung (10) zum Umwandeln von Energie, insbesondere für ein elektrisches Antriebssystem einer Unterwasserkompressions- und -pumpstation, die ein Leistungsmodul (14), Mittel (16) zum Kühlen des Leistungsmoduls (14) und ein dichtes Gehäuse (12) für die Aufnahme des Leistungsmoduls (14) und wenigstens eines Teils der Kühlungsmittel (16) umfasst, wobei die Kühlungsmittel (16) umfassen:
- einen Kühlkreis (18), in dem ein Wärmeaustauschfluid zirkuliert,
- einen ersten Wärmetauscher (22) mit dem Leistungsmodul (14), durch den sich das Wärmeaustauschfluid des Kühlkreises (18) bewegt, und
- wenigstens eine Pumpe (24) zum zirkulierenden Antreiben des Wärmetauscherfluids in dem Kreis (18),
**dadurch gekennzeichnet, dass**:
- das Gehäuse (12) eine Zone (26) für die Aufnahme des Wärmeaustauschfluids, die mit dem Wärmeaustauschfluid gefüllt ist, aufweist,
- der Kühlkreis (18) eine Eingangsöffnung (28) in den Kreis (18), die stromaufseitig der Antriebspumpe (24) ausgespart ist und in das Wärmeaustauschfluid in der Aufnahmezone (26) mündet, aufweist.

2. Energieumwandlungsvorrichtung (10) nach Anspruch 1, wobei die Eingangsöffnung (28) mit einem Rückschlagventil (30) versehen ist, das nur die Bewegung des Wärmeaustauschfluids von der Aufnahmezone (26) in den Kühlkreis (18) zulässt.

3. Energieumwandlungsvorrichtung (10) nach Anspruch 1 oder 2, das einen Filter (32) umfasst, der zwischen der Eingangsöffnung (28) und dem Kreis (18) angeordnet ist.

4. Energieumwandlungsvorrichtung (10) nach einem der vorhergehenden Ansprüche, wobei das Wärmeaustauschfluid ein dielektrisches Fluid, beispielsweise ein dielektrisches Öl ist.

5. Energieumwandlungsvorrichtung (10) nach einem der Ansprüche 1 bis 4, wobei die Antriebspumpe (24) in der Aufnahmezone (26) in der Weise angeordnet ist, dass sie in das Wärmeaustauschfluid dieser Aufnahmezone (26) eingetaucht ist.

6. Energieumwandlungsvorrichtung (10) nach Anspruch 5, wobei sich die Aufnahmezone (26) in dem Gehäuse (12) in der Weise erstreckt, dass der Kühlkreis (18) in das Wärmeaustauschfluid in dieser Aufnahmezone (26) eingetaucht ist.

7. Energieumwandlungsvorrichtung (10) nach einem der Ansprüche 1 bis 4, wobei der Kühlkreis (18) über der Aufnahmezone (26) angeordnet ist und mit einer Saugleitung (34) versehen ist, die sich von einer stromaufseitig der Antriebspumpe (24) angeordneten Verzweigung (36) bis zu der Eingangsöffnung (28) erstreckt, die in das Wärmeaustauschfluid der Aufnahmezone (26) eingetaucht ist.

8. Energieumwandlungsvorrichtung (10) nach einem der Ansprüche 1 bis 7, wobei das Gehäuse (12) mit Ausnahme der Aufnahmezone (26), die mit dem Wärmeaustauschfluid gefüllt ist, mit Gas, vorzugsweise Neutralgas, beispielsweise Stickstoff, gefüllt ist.

9. Energieumwandlungsvorrichtung (10) nach einem der Ansprüche 1 bis 7, wobei die Aufnahmezone (26) sich im gesamten Gehäuse (12) erstreckt, wobei die Energieumwandlungsvorrichtung eine Vorrichtung (38) zur Druckbegrenzung aufweist, die dazu bestimmt ist, den Druck im Gehäuse (26) zu begrenzen, indem sie teilweise das Wärmeaustauschfluid aufnimmt, das dieses Gehäuse (12) füllt, wenn sich dieses Wärmeaustauschfluid ausdehnt.

10. Elektrisches Antriebssystem für Unterwasserkompressions- und -pumpstation, das wenigstens eine Energieumwandlungsvorrichtung (10) nach einem der vorhergehenden Ansprüche umfasst.

## Claims

1. Energy conversion device (1), in particular for an electric drive system of an underwater compression and pumping station, comprising a power module (14), means (16) for cooling the power module (14), and a sealed housing (12) for accommodating the power module (14) and at least part of the cooling means (16), the cooling means (16) comprising:
- a cooling circuit (18) in which a coolant fluid circulates,
- a first heat exchanger (20) with the power module (14), through which the coolant fluid from the cooling circuit (18) passes, and
- at least one pump (24) for driving the coolant fluid in circulation within the circuit (18),
**characterised in that**:
- the housing (12) comprises a coolant fluid receiving zone (26) filled with coolant fluid,
- the cooling circuit (18) comprises an inlet opening (28) into the circuit (18), arranged upstream of the drive pump (24) and opening into the coolant fluid of the receiving zone (26).

2. Energy conversion device (10) according to claim 1, wherein the inlet opening (28) is fitted with a non-return valve (30) which authorises the passage of the coolant fluid only from the receiving zone (26) to the cooling circuit (18).

3. Energy conversion device (10) according to claim 1 or 2, comprising a filter (32) arranged between the inlet opening (28) and the circuit (18).

4. Energy conversion device (10) according to any of the preceding claims, wherein the coolant fluid is a dielectric fluid, for example a dielectric oil.

5. Energy conversion device (10) according to any of claims 1 to 4, wherein the drive pump (24) is arranged in the receiving zone (26) so as to be immersed in the coolant fluid of this receiving zone (26).

6. Energy conversion device (10) according to claim 5, wherein the receiving zone (26) extends into the housing (12) such that the cooling circuit (18) is immersed in the coolant fluid of this receiving zone (26).

7. Energy conversion device (10) according to any of claims 1 to 4, wherein the cooling circuit (18) is arranged above the receiving zone (26) and is fitted with an aspiration hose (34) which extends from a branch (36) arranged upstream of the drive pump (24) as far as the inlet opening (28) which is immersed in the coolant fluid of the receiving zone (26).

8. Energy conversion device (10) according to any of claims 1 to 7, wherein the housing (12), with the exception of the receiving zone (26) which is filled with coolant fluid, is filled with gas, preferably an inert gas, for example nitrogen.

9. Energy conversion device (10) according to any of claims 1 to 7, wherein the receiving zone (26) extends throughout the housing (12), the energy conversion device comprising a pressure limiting device (38) adapted to limit the pressure in the housing (12) by receiving part of the coolant fluid filling this housing (12) when the coolant fluid expands.

10. Electric drive system for an underwater compression and pumping station, comprising at least one energy conversion device (10) according to any of the preceding claims.
